# EUROPEAN PATENT SPECIFICATION

(11) **EP 2 069 586 B1**
(45) Date of publication and mention of the grant of the patent: **18.10.2017**
(21) Application number: 07815253.5
(22) Date of filing: 28.09.2007
(51) Int. Cl.: E04D 13/18, F24J 2/00, H01L 31/052

(54) **SOLAR ENERGY HARVESTING APPARATUS**
VORRICHTUNG ZUR GEWINNUNG VON SONNENENERGIE
APPAREIL DE RÉCUPÉRATION D'ÉNERGIE SOLAIRE

(30) Priority: 28.09.2006 AU 2006905353 P; 19.07.2007 AU 2007903888 P
(43) Date of publication of application: 17.06.2009
(73) Proprietor: Trac Group Holdings Ltd, Arundel QLD 4214 (AU)
(72) Inventor: MITCHELL, Keith, Baulkham Hills NSW 2153 (AU); BRAAT, Sebastian, Leura NSW 2780 (AU)
(74) Representative: Dolleymores
(86) International application number: PCT/AU2007/001436
(87) International publication number: WO 2008/037016

(56) References cited:
- WO-A1-02/053990
- FR-A1- 2 478 167
- JP-A- 2002 147 868
- US-A- 4 282 862
- US-A1- 2002 121 298
- US-A1- 2002 121 298
- PATENT ABSTRACTS OF JAPAN & JP 2002 147868 A (SEKISUI CHEMICAL CO LTD) 22 May 2002
- PATENT ABSTRACTS OF JAPAN & JP 56 146952 A (KUBOTA LTD) 14 November 1981

## Description

### BACKGROUND

The present invention relates to a solar energy harvesting apparatus, energy systems including the apparatus and methods of harvesting solar energy utilizing the apparatus. This invention has particular application (but is not limited to) roof mounted solar energy harvesting systems for domestic and industrial use, and for illustrative purposes the invention will be further described with reference to this application. The invention may find application in other methods and systems for harvesting solar energy including wall mounted and ground-based "broad acre" systems.

### PRIOR ART

The following examples of prior art apparatus are mere public knowledge are not to be construed as forming part of the common general knowledge in the art.

There are in existence a wide variety of solar energy systems including those which are installed on a roof of a structure such as a dwelling and which capture, via solar cells, solar energy which may be converted into an alternative form of energy to provide hot water, electricity or the like.

Many roof mounted solar systems have been described in the prior art. In general, a solar cell module is formed by interconnecting individual solar cells and laminating the interconnected cells into an integral solar cell module. More specifically, the module usually includes a stiff transparent cover layer made of a polymer or glass material, a transparent front encapsulant which adheres to the cover material and to a plurality of interconnected solar cells. The module also has a rear encapsulant which can be transparent or any other colour, a stiff backskin for protecting the rear surface of the module, a protective seal which covers the edges of the module, and a perimeter frame made of aluminium which covers the seal. The frame protects the edges of the module when the front cover is made of glass.

Before the frame is mounted, the module is laminated under heat and pressure. These conditions cause the layers of encapsulant material to melt, bond to adjacent surfaces, and to literally "encapsulate" the solar cells. Since crystalline silicon solar cells are usually brittle, the encapsulant serves to protect the solar cells and reduce breakage when the module is subject to mechanical stress during field usage. As can be seen from the above description the module is of relatively complicated construction.

In another example, United States Patent 5,986,203 discloses a solar cell roof tile and method of forming same. The patent describes a solar cell roof tile including a front support layer, a transparent encapsulant layer, a plurality of interconnected solar cells and a back skin layer. The front support layer is formed of light transmitting material and has first and second surfaces. The transparent encapsulant layer is disposed adjacent the second surface of the front support layer. The interconnected solar cells have a first surface disposed adjacent the transparent encapsulant layer. The backskin layer has a first surface disposed adjacent a second surface of the interconnected solar cells, wherein a portion of the backskin layer wraps around and contacts the first surface of the front support layer to form the border region.

For amorphous silicon solar cell modules, polymeric frames of a moulded thermoplastic material are widely practiced. Reaction injection moulding may be used to mould a polyurethane frame around an amorphous silicon module. Modules made this way tend to be small (e.g., 5-10 Watt size), not the 50-80 Watt size more generally deployed using aluminium frames. The modules tend to be smaller because of the higher cost of the mould and the limited strength of the resulting polymeric frame with its integral mounting holes.

For crystalline silicon modules, the backskin material is generally quite costly. There are two widely used backskin materials, both of which tend to be expensive. The most popular material used is a Tedlar^{®}/polyester/ethylene vinyl acetate laminate, and the other widely used backskin material is glass. Two additional layers of material are often deployed between the solar cells in the module and the backskin, further adding to the manufacturing costs. A rear sheet of the same material as the transparent encapsulant, (e.g., Ethylene Vinyl Acetate) may be provided.

Both amorphous and crystalline silicon modules also include a junction box which is mounted onto the backskin material and from which all external electrical connections are made.

The labour intensive process of mounting the module can add significantly to the overall cost of solar electricity. Modules are mounted by assembling screws, nuts, and bolts to the appropriate mounting holes on the aluminium frame. However, solar cell modules are often located in remote areas which have no other source of electricity. As such, the mounting process often involves attaching the hardware in difficult, awkward and not readily accessible locations such as on rugged terrain, or roof tops. The aforesaid discussion demonstrates that the manufacture of solar cell modules tends to be too costly and involves too much labour to allow for the realization of the goal of cost-competitive solar power. The prior art teaches a low-cost solar cell module that can be used as a roof tile.

United States Patent 6,294,724 discloses a solar cell module and power generation apparatus comprising a solar cell element, a front surface member provided at a light receiving surface side of the solar cell element, and a back surface member provided at the back surface side of the solar cell element. The front surface member and the back surface member are adjoined in a releasable state. At least the front surface member and the solar cell element are in close contact or the front surface member is in close contact with a solid layer which is in close contact with the solar cell element.

In another example of the prior art devices United States Patent 6,453,629 discloses a roofing tile having photovoltaic module to generate power. The roofing tile for performing solar-light power generation includes a roofing tile main body set tilted on a roof, and a photovoltaic module fixed to the main body. The roofing tile main body has a recess open upward. The photovoltaic module is stored and fixed in the recess. The roofing tile main body has an eaves-side edge portion. This edge portion has a plurality of drain ditches. Each drain ditch crosses the upper portion of the eaves-side edge portion and communicates with the recess. The level of the bottom surface of each drain ditch is equal to or lower than that of the bottom surface of the recess. With this construction, rainwater that has entered the recess is discharged through the drain ditches. Rainwater is drained by running the rainwater downward on the upper surface side of the eaves-side edge portion along the tilt direction of the roofing tile.

A photovoltaic module for converting solar-light energy into electrical energy is known. A technique of using such a module mounted on a roofing tile used as roofing material for a building is disclosed in, e.g., Jpn. Pat. Appln. KOKAI Publication Nos. 10-88741, 10-115051, and 10-325216. The photovoltaic module is fixed on a roofing tile main body by direct bonding to the roofing tile main body with an adhesive. A second method of fixing is disclosed in Jpn. Pat. Appln. KOKAI Publication No. 11-1999: The roofing tile main body has a recess in which a photovoltaic module is bonded to the bottom surface of the recess with an adhesive, and the gap between the photovoltaic module and the inner peripheral surface of the recess is filled with a caulking material.

The problem with that method is that the adhesive or caulking material readily degrades especially in, e.g., a rooftop environment where it is exposed to sun and increases its temperature, or open to wind and rain. If the adhesive or caulking material degrades to form cracks, rainwater or dust may enter the gap between the roofing tile main body and the photovoltaic module through the cracks.

Jpn. Pat. Appln. KOKAI Publication No. 10-88741 discloses an arrangement in which a photovoltaic module is stored in a recess of a plain roofing tile, and a through hole communicating with the reverse side of the roofing tile is formed at the eaves-side edge of the plain roofing tile.

In the roofing tile disclosed in Jpn. Pat. Appln. KOKAI Publication No. 10-115051, a photovoltaic module is stored in a recess. The upper surface of the eaves-side edge portion of this roofing tile is formed to be flush with that of the photovoltaic module almost without forming any step therebetween. At the left and right edge portions, the upper surface of the roofing tile projects from that of the photovoltaic module. This prior art describes the arrangement for making rainwater smoothly run on the surface of the roofing tile, though discharge of rainwater that has entered the recess of the roofing tile.

A common method used by existing integrated PV solutions is to cut the surrounding tiles to suit the PV panel and fit flashing to waterproof the installation. This approach is not aesthetically pleasing but also requires additional labour and expertise, adding both labour and material costs to a job.

US2002/0121298 A1 shows another known solar energy harvesting apparatus.

### INVENTION

Unless context indicates to the contrary the word "comprises" and its parts are to be taken to be non-exclusive. The present invention resides in a solar energy harvesting apparatus according to claim 1. The substrate may be a roof structure or the like. The body is configured to integrate with the standard tiles of a tiled roof structure.

The body includes a transparent front face enclosing the absorber. Clear polycarbonate, acrylic or toughened glass may be used to form the body, with final material choice based on durability, clarity/UV stability, resistance to clouding and impact toughness. Polycarbonate for example has proven to be an excellent material for use as clear roof cladding and clear skylight applications, with products such as corrugated roof sheeting retaining clarity and toughness under constant exposure to the sun and weather. A preferred material is accordingly polycarbonate. Since this material is flexible, should the body suffer extreme load through misadventure such as an installer stepping onto the middle of the element, the body of the element may form a chassis allowing any solar components to pop out rather than break. This may save the consumer an expensive replacement part and may prevent the installer from falling through the roof cladding. The fitting of the solar elements to the body may be by simple 'push-in, snap-tight' fit.

Lenses and/or reflectors may be employed to accommodate changes in angle of sun's rays and/or function as a light collector. These may be incorporated into or added to an outer transparent front face of the body. For example, the front face may incorporate integral light collecting elements such as prismatic or lenticular sections. These may be adapted to run longitudinally down the pitch of the front face in use. When the pitch of the roof approaches the desirable angle for collectors for a given latitude, aligning lenticular concentrators with the constant lens section disposed across the pitch means the concentrators are effective for the greatest part of the day. The front face may have a treated outer surface to reduce reflection. The front face inner surface may be a reflecting inner surface.

The body may have a first surface which opposes and detachably engages a surface of a structure and a second exposed, heat collecting surface which collects rays and together define an internal space. The body may include, along a first edge a mating profile, and along a second opposite edge a corresponding mating profile. The mating profile along the first edge may be a male profile and the mating profile along the second end may be a female profile. Since the apparatus is in the form of a tile-like element, roofing screws used for the installation of steel and polycarbonate roof cladding may used by the installer to secure each tile element to roof battens. Polycarbonate tile elements according to the present invention may weigh as little as 1 kg making it much lighter than conventional concrete tiles. The use of a roofing screw may provide anchoring to prevent uplift of the tile elements by wind moving rapidly over the roof surface.

The thermal absorber is configured to absorb broadband solar radiation. That is, the absorber preferably approximates a thermodynamic black body. The thermal absorber may comprise an absorber plate including a coolant circulating array in circuit with a remote heat exchanger in a thermal storage such as a
hot water tank. System pressure is preferably restricted to reduce the specification of connectors and the like and to this end it is preferred that the system be thermosiphon in operation with the thermal storage above the absorbers. Otherwise, where a positive displacement system is necessary, this preferably operates at minimum pressure to alleviate the risk of leakage. However, if a leak does occur the water system is still above the roof sarking/ moisture barrier set in place to backup regular tiles against wind driven rain. Leakage may be detected by monitoring pressure or headspace flow.

The thermal absorber is associated with a photovoltaic element such as a PV cell. The thermal absorber is adapted to absorb incident solar radiation and transfer heat via the connector to a circulated-fluid system, the photovoltaic element being mounted on the absorber to control the temperature of the photovoltaic element. An interface between the photo-active portions of the photovoltaic element and the thermal absorber may be selected to reflect solar radiation at least substantially over the absorption bandwidth of the photovoltaic element.

The body includes a transparent front face enclosing both the absorber and photovoltaic cell. The solar energy harvesting elements are environmentally sealed within said body. The void space inside the body of a sealed assembly is minimized in order to reduce thermal cycling stresses and wasteful reflection of incoming sunlight.

According to one embodiment a void space clearance may be provided such as 4mm for all types of PV material (mono-crystalline, poly-crystalline and amorphous) and their respective backing material.

The photovoltaic element may comprise any photovoltaic element that is capable of integration with a thermal absorber and be regulated as to temperature thereby. For example, the photovoltaic element may be selected from thin-film material mounted on a reflective substrate. Preferably, the photovoltaic element is close thermal bonded to the thermal absorber. A tile-like body may for example support for example four 125mm polycrystalline PV cells wired in series to produce 8- 10 watts at 2.5V - 7.6 volts. The thermal absorber may function as a heat exchanger fixed to the back of the PV cells. The advantage of this is that waste heat generated by the PV cells is an additional thermal energy source. Drawing heat away from the cells in this fashion allows them to operate at lower temperatures at which they are most efficient. Cell manufactures typically rate their cells' power output at a temperature of 25-30 degrees C. In practice most cells operate well above this by reason of the combination of resistive heating and thermal absorption and so never work to their full potential. Thermally integrating the PV cell and thermal absorber/heat exchanger means that the cells may operate at a relatively constant temperature. By using the waste resistive heat and PV absorption heat to heat coolant for transfer of heat to, for example, a hot water system some advantage can be gained by reducing the power required to heat the household's hot water. The masking effect of the PV cells on the thermal absorber is ameliorated.

The photovoltaic element is therefore close-thermal-bonded to the thermal absorber. The interface between the photo-active portions of the photovoltaic element and the thermal absorber is preferably selected to reflect solar radiation at least substantially over the absorption bandwidth of the photovoltaic element. By this means the photoactive material may interact with reflected photons of sufficient energy that have passed through the material on incidence.

The modular nature of the elements provides the option of using a broad range of solar cell technology such as: poly or mono crystalline photovoltaic (PV) elements including sliver cells; amorphous PV elements; and chemical dye artificial photosynthesis (such as DYESOL^{®} products). This ensures the elements will always provide the user with the most current solar power option, and the manufacturer with an easily updatable platform to work on.

In particular embodiments of the present invention the apparatus comprises a detachable tile element which is adapted to fit to existing tile profiles to form, collectively with like tile elements, solar energy cell arrays. These embodiments
represent a method of solar power generation on a surface of a structure using detachable fitment of solar tile elements. The detachable solar tile elements may comprise a polycarbonate body defining the internal space and into which is fitted at least one solar cell, a heat absorber, and associated electrical and water connectors.

The element may be a cladding element having a main body having a first surface which opposes and detachably engages a surface of a structure and a second upper exposed heat collecting surface which collects rays, the first and second surfaces together defining an internal space, the internal space including at least one photovoltaic cell, the tile attachment or cladding further comprising along a first edge a mating profile and along a second opposite edge a corresponding mating profile. The cladding element may engage an adjacent roofing tile such that the upper surface of the cladding element continues the roof tile profile. The cladding element may have a profile which allows fitting to a corrugated or other cladding sheet profile.

The solar active components may be sandwiched between opposing sheets of polycarbonate forming the body. Alternatively, the solar active components may be laminated to a surface of a polycarbonate sheet.

A plurality of solar elements may combine to form a cladding which overlays existing roofing. The integrated elements may provide, in addition to a solar ray collector, a roof secondary cladding with no modification required to a new or retrofitted installation. The elements may be simply fitted to the existing roof and interlocked with at least one adjacent element to form the secondary cladding and solar collector. The elements are simple to install onto a new or existing roof structure, thereby reducing installation costs and allowing homeowners to fit the elements to, for example, tile roofs.

A solar energy harvesting system may include a plurality of solar energy harvesting apparatus described above. The solar energy harvesting system may be formed of solar energy harvesting apparatus including a photovoltaic cell and wherein the connection includes a parallel electrical connection. The elements may be connected electrically in parallel to a cable harness by any suitable means. For example, elements may be connected electrically in parallel by snap-in electrical connectors. The parallel connection may be made between groups of said solar energy harvesting apparatus connected in series. This is especially so where the harness voltage is selected to be higher than the notional PV cell voltage to reduce conductor size and/or supply a higher-voltage storage system.

In another aspect the present invention resides broadly in a solar energy harvesting system including a plurality of solar elements in assembly, each characterised by the features of claim 1. The circulated-fluid array may include a fluid connection from each element by any suitable means. Thermal absorbers connected to fluid circulation systems generally have an inlet connection and an outlet connection. These may be a fluid connection from each element to double tubing connecting to the hot and cold sides respectively of a thermosiphon header. The fluid connections may be made by self-sealing, piercing connectors adapted to pierce the double tubing. The circulated-fluid system may involve the use of a thermally massive heat exchange liquid. The liquid may be any suitable heat exchange liquid including aqueous, oleaginous or glycolic liquids.

The electrical connection may be in parallel to the cable harness by simply-installed means such as a snap-in electrical connector. An example of such connectors are automotive-style, two-pole connectors snap connectors. The circulated-fluid system may include double tubing connecting to the hot and cold sides respectively of a thermosiphon header. The electrical and circulated-fluid connections may be integrated into a single physical connector. The fluid connection may be made by a self-sealing, piercing connector adapted to pierce the double tubing. The circulated-fluid system and electrical harness may each be connectable to a plurality of other solar energy harvesting apparatus to form a solar energy harvesting system.

Embodiments of the present invention may be optimized as to casing material, backing sheet material, PV cell reflective material, encapsulant refractive index, fluid temperature and flow control to create both the maximum amount of PV electrical output and the maximum amount of gross energy (heat plus solar PV) over a range of solar conditions. The capture of radiant solar energy may be optimized by using a casing material with excellent transmission characteristics in the visible spectrum, especially between the red and green section of the spectrum, a treated outer surface to reduce reflection, with a reflecting material on the inner side, to cause internal reflection of light rays being reflected in turn through the solar cell material from the substrate. Solar PV electric energy capture may be optimized by using thin-film cell technology together with a reflective material on the substrate. Total thermal energy capture may be optimized by close thermal bonding by suitable agents of the base of the cell substrate to the cooling jacket and a dark jacket colour. Heat transfer may be optimised by the selection of a coolant temperature which maximises heat transfer firstly from the cell material to the coolant and then in turn to the hot water storage unit.

The elements may be fully modular and readily assembled, according to the power and hot water needs of the client, in the field with minimum skills. Each element may be made as a sealed unit, and may be fitted with two electrical leads and two fluid pipes connections. The elements may be connected in parallel, depending on individual element output voltage, by using runs of twin-conductor cable and snap-in electrical connectors at each connection point, one cable run per row, and connected in turn in parallel to a final cable run to an inverter or battery charging system. Connections may be a simple "snap-in" type assembly and may operate at low voltage avoiding the use of licensed tradesmen.

The fluid connection may be similar to the electrical connection. The "hot" and "cold" pipes may be connected to a run of double tubing, which in turn may be connected to "hot" and "cold" tubing leading to a hot fluid header, located physically close to the top of the roof structure, from which in turn "hot" and "cold" pipes may be taken to the hot water storage unit and its associated heat exchanger. By using parallel connections, any number of elements could be chosen to suit the client's needs and budget, without complicating the electrical and fluid design.

The elements may be fully integrated with coolant fluid and electrical connections all fully sealed to ensure maximum life and reliability, with the outer casing/PV cell/substrate/cooling jacket designed and manufactured as a complete single unit. The inner workings (PV cell and coolant jacket) may be fully enclosed by the outer casing, which as described previously may be transparent on the top surface but not necessarily so underneath. Only the two electrical leads and fluid tubes need protrude beyond the casing. It may be fully sealed during manufacture to prevent moisture ingress and prevent accidental tampering with the element on site.

Once fitted, an electrician is required to wire an inverter and the grid connection,
The polycarbonate elements can be cut into roof hips and valleys allowing greater coverage of modern roof configurations. Alternatively the elements may be used to provide an integrated skylight array.

Embodiments of the present invention may adapt the elements to a variety of roof layouts with different types and brands of roof tile profiles including concrete tiles. Variation in the vertical tile batten gauge and horizontal lapping leads to 'layout creep', which means larger panels formed form the elements that might cover the space of several tiles will due to cumulative error run out of alignment when inserted into an existing layout. This misalignment may also occur due to slight differences in various manufacturers' versions of the same concrete tile profile which makes a universal solution difficult without the use of complex snap-off arrangements that allow each panel to be custom fitted. The overlap and underlap heights above the tile batten for each profile are also different and don't allow a correct fit when differing profiles are laid side by side.

Embodiments of the present invention may reduce the labour costs of a solar power installation. Embodiments of the present invention may provide a detachable element for fitting to a roof tile which fits seamlessly onto existing tile profile shapes.

Embodiments of the present invention may provide a solar cell element which conforms closely to the dimensions of a tile to which the element is fitted and which allows for cumulative error which may otherwise be created by horizontal and vertical overlaps, thereby providing a close fit so that the element follows the existing roof tile layout accurately.

### BRIEF DESCRIPTION OF DRAWINGS

The invention will now be described in more detail according to a preferred but nonlimiting embodiment and with reference to the accompanying illustrations wherein:
Figure 1 shows a schematic layout of a typical solar energy installation which employs an array of solar cell elements according to one embodiment of the invention;
Figure 2 shows an exploded view of a solar element assembly according to an embodiment;
Figure 3 shows a bottom exploded view of the solar element assembly of figure 2;
Figure 4 is a section through a typical sealed assembly of the present invention;
Figure 5 is a schematic drawing of the power connections of a solar array in accordance with the present invention;
Figure 6 is a schematic drawing of the circulating-fluid connections of a solar array in accordance with the present invention; and
Figure 7 is a section though a typical fluid connection polymer tube for use in the array of Figure 6.

### DESCRIPTION OF THE EMBODIMENT

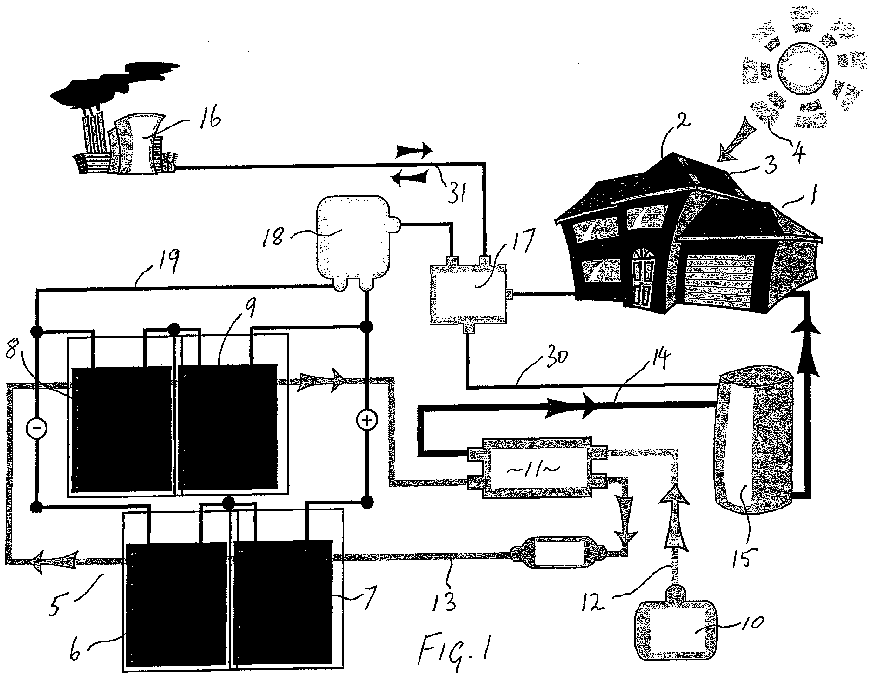

The arrangement shown in **figure 1** comprises a dwelling 1 having a roof 2, which has located thereon an array 3 of PV/thermal solar cell elements, which receive solar rays 4. Array 3 is shown in an enlarged configuration 5, which comprises sets of elements 6, 7, 8 and 9. Water supply 10 provides a source of cold water to heat exchanger 11 via inlet pipe 12. Exchanger 11 delivers a coolant to elements 6, 7, 8, and 9 via coolant line 13. Elements 6 and 7 are in parallel with elements 8 and 9. Coolant line 13 takes supercharged coolant back to the heat exchanger, which heats water and delivers hot water via line 14 to hot water tank 15 for consumption in house 1. The system described thus far is similar to known solar systems for creating hot water except that in the embodiment shown the elements 6, 7, 8 and 9 are adapted to an existing tile roof.

On the power side, the house 1 is conventionally served by a mains AC grid, symbolically represented by the power station 16, by a switching assembly 17 including a conventional meter and circuit breaker/main switch assembly. However, the switching assembly 17 has a further input from a DC to AC inverter assembly 18 which includes a storage battery adapted to be charged by PV-generated current from the array elements 6, 7, 8 and 9. The inverter assembly 18 is configured to accept current at the load voltage of the individual array elements 6, 7, 8 and 9 by parallel circuits 19. The hot water storage 15 is boosted when necessary by mains current via cable 30. The inverter assembly 18 includes switching means that senses when the storage is full and household demand is less that the output of the array elements 6, 7, 8 and 9, and directs in-phase, mains-voltage AC back to the grid 16 via the switching assembly 17 and supply lines 31.

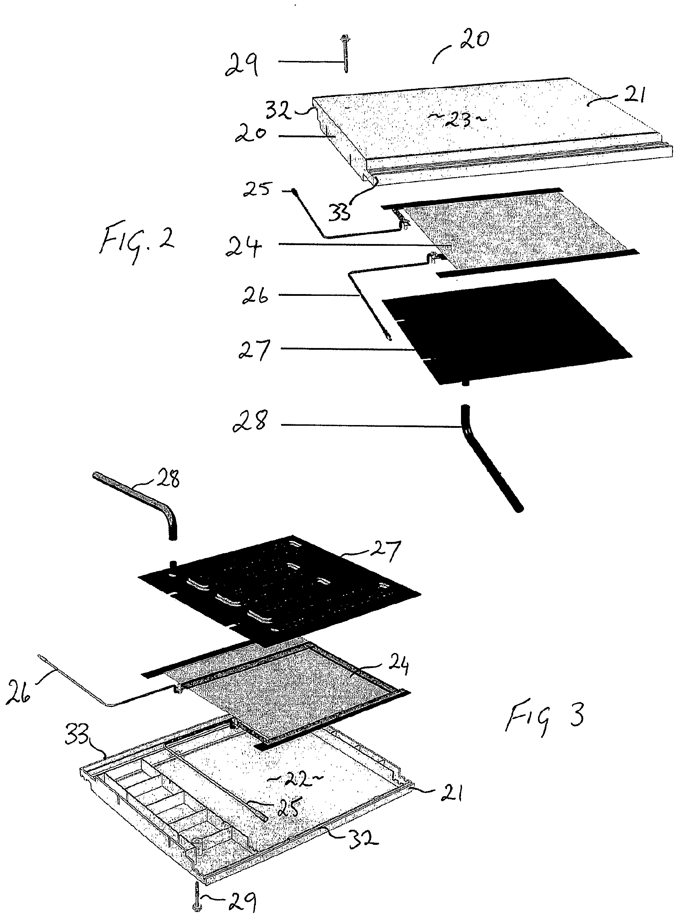

**Figure 2** shows an exploded view of a solar element assembly 20 according to a preferred embodiment. Solar element 20 comprises housing 21 having an inner surface 22 and outer surface 23, which defines an internal space which receives and retains therein a photovoltaic cell 24. Cell 24 includes DC connection wires 25 and 26, which provide connecting circuitry for the solar element 20. Assembly 20 further comprises a polymer heat exchange vessel 27 and polymer tubing 28. The assembly has side profiles 32, 33 enabling integration into the roof structure with each element being secured to a roof batten by a single batten screw 29. **Figure 3** represents a bottom or inverted view of figure 2 with corresponding numbering.

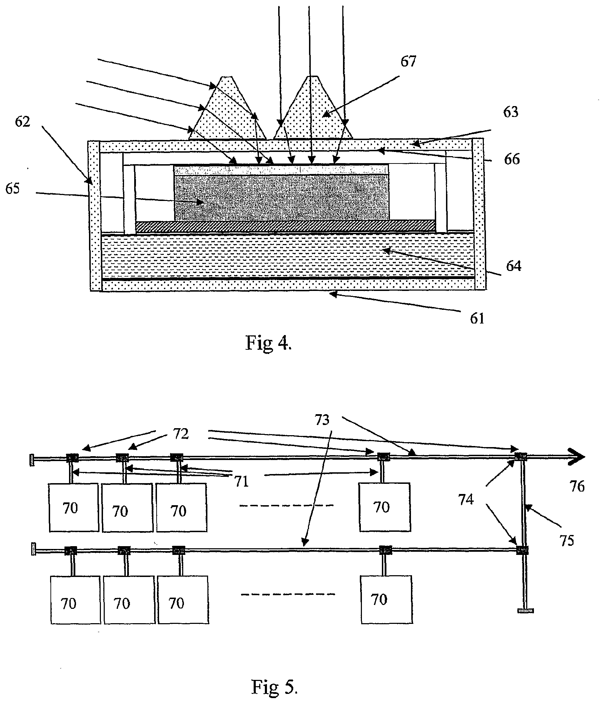

**Figure 4** shows a typical sealed assembly of the present invention, wherein a polycarbonate body includes a back 61, sidewall portions 62 and a front face portion 63 to form a sealed space. Within the sealed space is a thermal absorber 64 having close-thermal bonding thereto a PV cell 65 comprising n-type, p-type and backing layers (exaggerated as to scale for clarity). The inner face 66 of the front face portion 63 is relatively reflective by coating. The outer surface of the front face portion 63 has integral prismatic concentrators 67 formed therewith. The void space about the cell 65 is occupied by transparent encapsulant 68.

**Figure 5** shows the power connections of a solar system comprising a plurality of tile-like solar elements 70 each having a two-core electrical connection lead-in 71 terminated by a two-pole, snap-in connector 72. The roofing battens support "figure-eight" two-core cable 73, which is adapted to be engaged by insulation-piercing elements of the snap-in connectors 72. Further connectors 74 connect each batten cable 73 to a trunk cable 75 connecting to battery storage and/or inverter at 76.

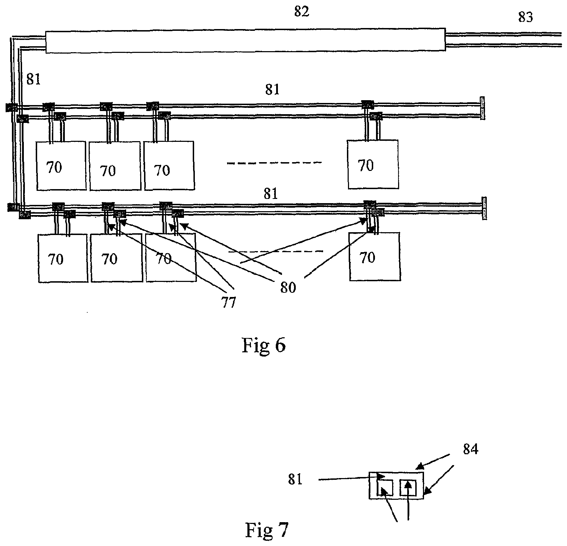

**Figure 6** shows the circulating-fluid connections of a solar system where tile-like solar elements 70 each have hot 77 and cold 80 coolant conduit tails paired together and connecting to respective hot and cold bores of double tube manifolding 81 of heat resistant plastic. The connection is made by self-piercing termini of the tails 77, 80. The circulation is by thermosiphon to and from a header tank 82. The header tank 82 heats a remote hot water storage via heat exchange pipes 83. The double tube manifolding 81 is illustrated in section in **Figure 7** wherein the section has flat faces 84 to which the piercing connections may gasket, and square bores 85 to ensure consistent wall thickness. The piercing connection includes retaining lugs adapted to hook the back flat of the double tube manifolding to retain the connection.

It will be recognised by persons skilled in the art that numerous variations and modifications may be made to the invention as broadly described herein without departing from the scope of the invention as described herein and defined in the claims appended hereto.

## Claims

1. A solar energy harvesting apparatus including a body (20) supporting a solar energy harvesting thermal absorber (27, 64) and a photovoltaic element (24, 65), a mounting (32, 33, 29) for engaging said body with a substrate, a connector (28) selected to integrate said thermal absorber functionally with other solar energy harvesting apparatus to form a solar hot water system, and connecting circuitry (25, 26) to said photovoltaic element, wherein the thermal absorber is configured to thermally absorb broadband solar radiation, **characterised in that** the photovoltaic element is thermally bonded to said thermal absorber which comprises a polymer absorber, said body including a transparent front face (23) environmentally sealing both the absorber and photovoltaic element within said body (20) and the void space inside the body is minimized, and wherein the body includes, along a first edge a mating profile (32), and along a second opposite edge a corresponding mating profile (33), the edge mating profiles (32, 33) on said body configured to engage with a standard-tiled roof structure to replace some of the standard tiles thereof.

2. A solar energy harvesting apparatus according to claim 1, wherein said front face (23) has one or both of a treated outer surface to reduce reflection and a reflecting inner surface (66).

3. A solar energy harvesting apparatus according to claim 1, wherein the transparent front face includes integral light collecting elements (67).

4. A solar energy harvesting apparatus according to claim 3, wherein the integral concentrating elements comprise prismatic or lenticular sections (67) adapted to run longitudinally down the pitch of the front face in use.

5. A solar energy harvesting apparatus according to claim 1, wherein the solar hot water system includes a coolant circulating array (81) in circuit with a remote heat exchanger (82, 83) in a thermal storage.

6. A solar energy harvesting apparatus according to claim 1, wherein an interface between the photo-active portions of the photovoltaic element (65) and the thermal absorber (64) is selected to reflect solar radiation at least substantially over the absorption bandwidth of the photovoltaic element.

7. A solar energy harvesting apparatus according to claim 1, wherein the photovoltaic element (24, 65) is selected from poly or mono crystalline photovoltaic (PV) elements; amorphous PV elements; and chemical dye artificial photosynthesis elements.

8. A solar energy harvesting apparatus according to claim 1, comprising a detachable tile element (20) to form, collectively with like tile elements, a solar energy cell array, the detachable solar tile elements comprising a polycarbonate body (61, 62, 63) defining the internal space and into which is fitted at least one solar cell (65) as said photovoltaic element, said thermal absorber (64), and associated electrical (72) and water (77, 80) connectors.

9. A solar energy harvesting system comprising an interconnected array of apparatus in accordance with any one of claims 1 to 10.

10. A solar energy harvesting system according to claim 9, wherein the thermal absorbers (27, 64) each have an inlet connection (77) and an outlet connection (80) to the hot and cold sides respectively of a fluid circulation system including a thermosiphon header (82).

11. A solar energy harvesting system according to claim 10, wherein the inlet (77) and outlet (80) connections are made by self-sealing, piercing connectors adapted to pierce double tubing (81) comprising the circulation system.

12. A solar energy harvesting apparatus according to claim 1, wherein said electrical connector (25, 26) is connectable to an electrical harness (73, 75) and wherein the electrical connection is in parallel to the electrical harness by a snap-in electrical connector (72).

## Patentansprüche

1. Eine Vorrichtung zur Gewinnung von Sonnenenergie, die einen Körper (20), der einen thermischen Absorber (27, 64) zur Gewinnung von Sonnenenergie und ein fotovoltaisches Element (24, 65) stützt, eine Halterung (32, 33, 29) zum Kuppeln des Körpers mit einem Substrat, einen Verbinder (28), der selektiert wurde, um den thermischen Absorber funktionell mit anderer Vorrichtung zur Gewinnung von Sonnenenergie zu integrieren, um ein Solar-Warmwassersystem zu bilden und Verbindungsschaltung (25, 26) zum fotovoltaischen Element einschließt, wobei der thermische Absorber konfiguriert ist, Breitbandsonnenstrahlung thermisch zu absorbieren,
**dadurch gekennzeichnet, dass** das fotovoltaische Element thermisch mit dem thermischen Absorber verbunden ist, der einen polymeren Absorber umfasst, wobei der Körper eine transparente Vorderfläche (23) einschließt, die umweltbedingt sowohl den Absorber als auch das fotovoltaische Element innerhalb des Körpers (20) abdichtet und der Hohlraum im Innern des Körpers wird minimiert, und wobei der Körper entlang einer ersten Kante ein Passprofil (32) und entlang einer zweiten gegenüberliegenden Kante ein entsprechendes Passprofil (33) einschließt, wobei die Kanten-Passprofile (32, 33) am Körper konfiguriert sind sich mit einer normalen Ziegeldachstruktur zu kuppeln, um einige der normalen Dachziegel davon zu ersetzen.

2. Eine Vorrichtung zur Gewinnung von Sonnenenergie nach Anspruch 1, wobei die Vorderfläche (23) eine oder beide einer behandelten äußeren Oberfläche, um Reflexion zu reduzieren, und eine reflektierende innere Oberfläche (66) aufweist.

3. Eine Vorrichtung zur Gewinnung von Sonnenenergie nach Anspruch 1, wobei die transparente Vorderfläche integrale Lichtsammelelemente (67) einschließt.

4. Eine Vorrichtung zur Gewinnung von Sonnenenergie nach Anspruch 3, wobei die integralen konzentrierenden Elemente prismatische oder linsenförmige Abschnitte (67) umfassen, die angepasst sind, um longitudinal der Neigung der Vorderfläche hinab, aktiv, zu verlaufen.

5. Eine Vorrichtung zur Gewinnung von Sonnenenergie nach Anspruch 1, wobei das Solar-Warmwassersystem eine Kühlmittel-Umlaufanordnung (81) einschließt, die an einen fernen Wärmetauscher (82, 83) in einem thermischen Speicher angeschlossen ist.

6. Eine Vorrichtung zur Gewinnung von Sonnenenergie nach Anspruch 1, wobei eine Schnittstelle zwischen den fotoaktiven Teilen des fotovoltaischen Elements (65) und dem thermischen Absorber (64) selektiert wird, um Sonnenstrahlung mindestens im Wesentlichen über die Absorptions-Bandbreite des fotovoltaischen Elements zu reflektieren.

7. Eine Vorrichtung zur Gewinnung von Sonnenenergie nach Anspruch 1, wobei das fotovoltaische Element (24, 65) aus poly- oder monokristallinen fotovoltaischen (PV) Elementen; amorphen PV-Elementen; und chemischen Farbstoff-Fotosyntheseelementen wird.

8. Eine Vorrichtung zur Gewinnung von Sonnenenergie nach Anspruch 1, die ein lösbares Ziegelelement (20) umfasst, um kollektiv mit ähnlichen Ziegelelementen, eine Anordnung von Sonnenenergiezellen zu bilden, wobei die lösbaren Solar-Ziegelelemente einen Körper (61, 62, 63) aus Polycarbonat umfassen, der den Innenraum definiert und in den mindestens eine Solarzelle (65) als das fotovoltaische Element, der thermische Absorber (64) und zugehörige elektrische (72) und Wasseranschlüsse (77, 80) angebracht werden.

9. Ein System zur Gewinnung von Sonnenenergie, das eine miteinander verbundene Anordnung von Vorrichtungen in Übereinstimmung mit einem der Ansprüche 1 bis 10 umfasst.

10. Ein System zur Gewinnung von Sonnenenergie nach Anspruch 9, wobei die thermischen Absorber (27, 64) jeweils eine Eingangsanschluss (77) und einen Ausgangsanschluss (80) zu den warmen bzw. kalten Seiten eines Flüssigkeitsumlaufsystems aufweisen, das ein Thermosiphon-Hauptrohr (82) einschließt.

11. Ein System zur Gewinnung von Sonnenenergie nach Anspruch 10, wobei die Eingangs-(77) und Ausgangsanschlüsse (80) durch selbstdichtende Schnellanschlüsse hergestellt werden, die angepasst sind, Doppelrohrleitung (81) zu durchstechen, die das Umlaufsystem, umfasst.

12. Eine Vorrichtung zur Gewinnung von Sonnenenergie nach Anspruch 1, wobei der elektrische Anschluss (25, 26) an einen elektrischen Kabelbaum (73, 75) anschließbar ist, und wobei der elektrische Anschluss durch einen elektrischen Rastanschluss (72) parallel zum elektrischen Kabelbaum ist.

## Revendications

1. Appareil de récupération d'énergie solaire comprenant un corps (20) supportant un absorbeur thermique de récupération d'énergie solaire (27, 64) et un élément photovoltaïque (24, 65), une monture (32, 33, 29) servant à des fins de mise en prise dudit corps avec un substrat, un connecteur (28) sélectionné pour intégrer ledit absorbeur thermique de manière fonctionnelle avec un autre appareil de récupération d'énergie solaire pour former un système d'eau chaude solaire, et un circuit de connexion (25, 26) sur ledit élément photovoltaïque, dans lequel l'absorbeur thermique est configuré à des fins d'absorption thermique du rayonnement solaire à large bande,
**caractérisé en ce que** l'élément photovoltaïque est thermiquement lié audit absorbeur thermique qui comporte un absorbeur polymère, ledit corps comprenant une face avant transparente (23) servant à des fins d'étanchéité à la fois de l'absorbeur et de l'élément photovoltaïque à l'épreuve des intempéries à l'intérieur dudit corps (20) et l'espace vide à l'intérieur du corps est minimalisé, et dans lequel le corps comprend, le long d'un premier bord, un profil d'accouplement (32), et le long d'un deuxième bord opposé un profil d'accouplement correspondant (33), les profils d'accouplement (32, 33) des bords sur ledit corps étant configurés à des fins de mise en prise avec une structure de toiture en tuiles standard pour remplacer certaines des tuiles standard de celle-ci.

2. Appareil de récupération d'énergie solaire selon la revendication 1, dans lequel ladite face avant (23) a l'une ou les deux parmi une surface extérieure traitée servant à réduire la réflexion et une surface intérieure réfléchissante (66).

3. Appareil de récupération d'énergie solaire selon la revendication 1, dans lequel la face avant transparente comprend des éléments collecteurs de lumière intégrés (67).

4. Appareil de récupération d'énergie solaire selon la revendication 3, dans lequel les éléments de concentration intégrés comportent des sections prismatiques ou lenticulaires (67) adaptés à des fins d'acheminement dans le sens longitudinal le long de l'inclinaison de la face avant lors de l'utilisation.

5. Appareil de récupération d'énergie solaire selon la revendication 1, dans lequel le système d'eau chaude solaire comprend un réseau de circulation de caloporteur (81) en circuit avec un échangeur de chaleur à distance (82, 83) dans un dispositif de stockage thermique.

6. Appareil de récupération d'énergie solaire selon la revendication 1, dans lequel une interface entre les parties photo-actives de l'élément photovoltaïque (65) et l'absorbeur thermique (64) est sélectionnée pour refléter le rayonnement solaire au moins sensiblement sur la largeur de bande d'absorption de l'élément photovoltaïque.

7. Appareil de récupération d'énergie solaire selon la revendication 1, dans lequel l'élément photovoltaïque (24, 65) est sélectionné parmi des éléments photovoltaïques (PV) polycristallins ou monocristallins ; des éléments PV amorphes ; et des éléments photosynthétiques artificiels à colorant chimique.

8. Appareil de récupération d'énergie solaire selon la revendication 1, comportant un élément formant tuile détachable (20) servant à former, collectivement avec des éléments formant tuiles similaires, un réseau de cellules d'énergie solaire, les éléments formant tuiles détachables comportant un corps en polycarbonate (61, 62, 63) définissant l'espace interne et dans lequel est adaptée au moins une cellule solaire (65) comme ledit élément photovoltaïque, ledit absorbeur thermique (64), et des connecteurs électriques (72) et d'eau (77, 80) associés.

9. Système de récupération d'énergie solaire, comportant un réseau interconnecté d'appareils selon l'une quelconque des revendications 1 à 10.

10. Système de récupération d'énergie solaire selon la revendication 9, dans lequel les absorbeurs thermiques (27, 64) ont chacun un connexion d'entrée (77) et une connexion de sortie (80) au niveau des côtés chaud et froid respectivement d'un système de circulation de fluide comprenant une colonne à thermosiphon (82).

11. Système de récupération d'énergie solaire selon la revendication 10, dans lequel les connexions d'entrée (77) et de sortie (80) sont réalisées par des connecteurs à perçage du type auto-obturant adaptés pour percer un double tube (81) comportant le système de circulation.

12. Appareil de récupération d'énergie solaire selon la revendication 1, dans lequel ledit connecteur électrique (25, 26) est en mesure d'être connecté à un harnais électrique (73, 75) et dans lequel la connexion électrique est parallèle par rapport au harnais électrique par un connecteur électrique enfichable (72).
